Europäisches Patentamt

European Patent Office

Office européen des brevets

(11) Publication number: **0 034 910**
**B1**

(12) **EUROPEAN PATENT SPECIFICATION**

(45) Date of publication of patent specification: **09.01.85**

(21) Application number: **81300648.3**

(22) Date of filing: **18.02.81**

(51) Int. Cl.⁴: **H 01 L 21/22,** H 01 L 21/265

(54) **A method of manufacturing a semiconductor device, and a device so manufactured.**

| | |
|---|---|
| (30) Priority: **18.02.80 JP 18791/80** | (73) Proprietor: **VLSI Technology Research Association**<br>**4-28, Mita 1-chome Minato-ku**<br>**Tokyo 108 (JP)** |
| (43) Date of publication of application:<br>**02.09.81 Bulletin 81/35** | |
| (45) Publication of the grant of the patent:<br>**09.01.85 Bulletin 85/02** | (72) Inventor: **Nawata, Kazumasa**<br>**4290, Suge Tama-ku**<br>**Kawasaki-shi Kanagawa 214 (JP)**<br>Inventor: **Suzuki, Hirokazu**<br>**2-13-18-507, Chuo**<br>**Yamato-shi Kanagawa 242 (JP)** |
| (84) Designated Contracting States:<br>**DE FR GB NL** | |
| (56) References cited:<br>**DE-A-2 640 465**<br>**DE-A-2 739 662**<br>**US-A-4 013 489**<br>**US-A-4 085 499**<br>**US-A-4 144 106** | (74) Representative: **Bedggood, Guy Stuart et al**<br>**Haseltine Lake & Co. Hazlitt House 28**<br>**Southampton Buildings Chancery Lane**<br>**London WC2A 1AT (GB)** |

Courier Press, Leamington Spa, England.

Description

This invention relates to a method of manufacturing a semiconductor device, and a device so manufactured.

In general, a semiconductor integrated circuit (IC) comprises an input/output interface circuit for receiving input signals from external circuits and for sending output signals to external circuits, and an internal circuit for performing functions such as logical operations.

The input/output interface circuit and the internal circuit are respectively composed of various elements such as transistors, and with regard to the transistors, for example, the transistors of both the interface circuit and the internal circuit are generally formed simultaneously by the same manufacturing process.

However, a transistor which receives input signals from external circuits often receives external noise, for example an extremely high voltage, and therefore it is desirable for such an element to have a withstand voltage higher than that of transistors used in the internal circuit so that breakdown of the element as a result of receiving external noise can be reliably prevented.

There are many IC's in which the input/output interface circuit operates at a high voltage, for example 5V, while the internal circuit operates at a low voltage, for example 2V. In such a case also it is desirable for a transistor of the input/output interface circuit to have a withstand voltage higher than that of a transistor of the internal circuit.

A requirement for a relatively high withstand voltage can be met, for example in the case of a bi-polar transistor, by providing a large difference between the depths of a base region and an emitter region of the transistor.

Therefore, a transistor having a withstand voltage higher than that of a transistor in an internal circuit can be obtained by, for example, making the emitter region of the transistor of the input/output interface shallower than that of a transistor of the internal circuit while providing the input/output interface transistor and the internal circuit transistor with base regions of the same depth.

An IC comprising transistors having different junction depths can be manufactured using a conventional diffusion method or ion implantation method.

If a diffusion method is used, emitter diffusion or base diffusion is carried out twice respectively, to provide different junction depths. For this reason, use of a diffusion method brings about an increase in the number of manufacturing processes required.

When an ion implantation method is used, different junction depths can be established in the same ion implantation process by using a mask of a predetermined thickness. However, direct ion implantation into a semiconductor surface injures the semiconductor material crystalline structure, which results in an increase in leakage current.

Japanese laid-open patent specification No. 54-154287 discloses a method of manufacturing an IC wherein predetermined impurities are implanted into a silicon semiconductor substrate by an ion implantation method via an insulating film, for example a silicon oxide film, selectively provided with different thicknesses, whereby semiconductor regions of different resistance values and junction depths are formed simultaneously. According to this method, an IC comprising transistors having different junction depths can be realised without an increase in the number of manufacturing processes required, but as mentioned above, the result is an increase in transistor leakage current.

Damage to crystal structure at areas where ions are implanted is alleviated since implantation takes place via the silicon oxide film. However, since oxygen in the silicon oxide film recoils from impacts of ions moving into the silicon oxide film, defects are extended or increased in size.

Japanese laid-open patent specification Nos. 51-123071, 51-147969 disclose a method wherein different parts of an impurity doped polycrystalline silicon layer are caused to have different thicknesses, and thereby junctions of different depths can be formed.

Moreover, Japanese laid-open patent specification No. 51-150962 discloses a method wherein a single crystalline thin film, different parts of which have different thicknesses and different etching characteristics, for example, $Ga_{0.7}Al_{0.3}As$, is formed on a semi-conductor substrate, for example GaAs, and impurities are doped-in by a diffusion or ion implantation method via the thin film, and thereafter the thin film is removed by an etching method.

US—A—4 144 106 discloses a method of manufacturing an $I^2L$ device in which a collar region and a collector region are formed by diffusion steps at the same time. Windows are formed in oxide film. In the windows for forming the collar region and the collector region the surface of an epitaxial layer, in which the collar region and collector region are to be formed, is exposed. Polycrystal silicon is deposited and then selectively removed so that it completely covers the area of the collector. Thus polycrystal silicon is present in the collector region window but not in the collar region window. Diffusion of phosphorous then takes place, the collector region and the collar region having different diffusion depths by virtue of the presence of the polycrystal silicon in the collector window. The difference in diffusion depth is controllable by the thickness of the polycrystal silicon.

U.S.—A—4 125 426 discloses an emitter diffusion and a collector contact diffusion carried out by coating a polysilicon layer with phosphosilicate glass which acts as the source of the diffusion impurity.

According to the present invention there is provided a method of manufacturing a semiconductor device, comprising:—

forming an insulating film on a surface of a semiconductor substrate, said film having first and second diffusion windows and a third diffusion window therein, through which corresponding portions of said surface of the semiconductor substrate are exposed,

forming undoped polycrystalline semiconductor on the surface portions of the semiconductor substrate exposed in the first, second and third diffusion windows in the insulating film, the undoped polycrystalline semiconductor on the surface portion exposed in the first diffusion window and the undoped polycrystalline semiconductor on the surface portion exposed in the second diffusion window having different selected thicknesses,

forming, simultaneously, diffusion regions, of different junction depths, in portions of the semiconductor substrate associated with the surface portions exposed in the first and second diffusion windows, by diffusing impurities into the substrate via the first and second diffusion windows, in each case through the respective selected thickness of polycrystalline semiconductor formed in the window concerned, and

simultaneously doping the undoped polycrystalline semiconductor on the surface portion exposed in the third diffusion window by diffusion of impurity provided in a portion of the substrate associated with that surface portion into that undoped polycrystalline semiconductor.

An embodiment of the present invention can provide a method of manufacturing a semiconductor device wherein diffusion areas of different diffusion depths can be formed simultaneously in a substrate, and in which undoped polycrystalline semiconductor can be simultaneously doped by diffusion from the substrate.

An embodiment of the present invention can provide a method of manufacturing a semiconductor device wherein diffusion areas of predetermined diffusion depths can be formed without causing damage at junction areas of the semiconductor device.

An embodiment of the present invention can provide a method of manufacturing a semiconductor device wherein diffusion areas of different diffusion depths can be formed simultaneously by using undoped polycrystalline silicon, so that difficulties of control of amounts of doping impurity can be overcome.

An embodiment of the present invention can provide a method of manufacturing a semiconductor device wherein impurity diffusion into a semiconductor substrate can be controlled so as to reach desired depths, by effecting the impurity diffusion through an undoped polycrystalline silicon layer different parts of which are of different thicknesses.

An embodiment of the present invention can provide a method of manufacturing a semiconductor device wherein sheet resistivity of a polycrystalline silicon layer used in the method can be reduced as a result of diffusion of impurities from the upper surface of the undoped polycrystalline silicon layer.

An embodiment of the present invention can provide a method of manufacturing a semiconductor device wherein damage at diffusion junctions resulting from alloying of electrode wiring conductor and semiconductor substrate material can be prevented, by utilizing a polycrystalline silicon layer used for control of diffusion depth as underlying contact layer for the electrode wiring conductor.

In an embodiment of the present invention, an insulator diffusion mask having a plurality of diffusion windows is provided at a semiconductor substrate surface. Ordinary silicon oxide or silicon nitride film can be used as the diffusion mask. The diffusion mask can also function as an etch-stop for selective etching of polycrystal semiconductor as will be described later.

Each diffusion window is covered with polycrystal semiconductor material.

In a diffusion window through which a comparatively shallow diffusion area is to be formed comparatively thick polycrystalline semiconductor layer is formed. On the other hand, in a diffusion window through which a comparatively deep diffusion area is to be formed comparatively thin polycrystalline semiconductor layer is formed.

Differences in thickness of polycrystalline semiconductor layer (to provide for shallow and deep diffusion areas) can be obtained by sequential polycrystalline semiconductor layer stacking, for example by the lift-off method, or by initially forming a thick polycrystalline semiconductor layer and then making only a predetermined area of the layer thin, by an etching method.

A polycrystalline semiconductor layer can be formed by evaporation, sputtering or chemical vapour deposition (CVD) methods, etc. Of these methods, a low pressure CVD method is most widely employed. From this point of view, it is desirable to form a highly homogeneous polycrystalline semiconductor layer by a low pressure CVD method then to make predetermined areas of the layer thinner, by etching. For such etching, chemical etching can be employed, but reactive sputtering is desirable from the point of view of accuracy.

Selective oxidation using silicon nitride and subsequent removal of oxide film is also a desirable etching method, wherein the generation of oxide film can be well controlled. In some cases, there may be used a method wherein polycrystalline semiconductor layer is partly oxidised (namely, part of the thickness of the polycrystalline semiconductor layer is oxidised) and then the oxidised part of the polycrystalline semiconductor layer is removed.

After a polycrystalline semiconductor layer of differing thicknesses has been obtained, impurity diffusion is effected. The impurity diffusion may be effected by gas diffusion, solid to solid diffusion or ion implantation.

Impurity reaches the semiconductor substrate by passing through the different thicknesses of the polycrystalline semiconductor layer. Therefore, diffusion depth in the substrate is relatively shallow where the polycrystalline semiconductor layer is relatively thick, and diffusion depth in the substrate is relatively deep where the polycrystalline semiconductor layer is relatively thin.

When ion implantation takes place through a polycrystalline semiconductor layer oxygen is not implanted. This contrasts with the case in which ion implantation takes place through an $SiO_2$ film and therefore using the polycrystalline semiconductor layer comparatively fewer crystal defects are found.

Gas diffusion and solid to solid diffusion are the most desirable diffusion methods because these methods do not allow the generation of crystal defects such as can be seen to result when an ion implantation method is used, and therefore result in less leakage (so-called pipe) between collector and emitter, for example.

A method embodying the present invention whereby different diffusion depths can be provided, can be employed in the manufacture of a bipolar IC when it is required to establish different emitter depths in the bipolar IC for a particular purpose.

For example, in a large scale integrated circuit (LSI), the operating voltage of an input/output interface circuit is, in general, different from that of an internal circuit. Generally, since the interface circuit operates at a high voltage, a transistor having a comparatively small emitter depth in such a way as to have a high withstand voltage is used in the input/output interface circuit, and a transistor having a comparatively large emitter depth in such a way as to have a low withstand voltage and a high current amplification factor is used in the internal circuit.

On the other hand, in the case of a junction breakdown type programmable read-only-memory, even when the memory is constituted by a bipolar IC, the base of a transistor of a memory cell is comparatively thick, as compared with peripheral circuits, in order to maintain the withstand voltage of unwritten memory cells. Transistors having different base depths can also be formed by a method embodying the present invention.

A method of changing or controlling diffusion depth, embodying the present invention, can be adopted for partly changing (providing at different depths) the source and drain junction of MOS IC in accordance with any particular purpose. As explained previously, in an MOS LSI, the operating voltage of an input/output interface circuit is different from that of an internal circuit and in general the interface circuit is so designed that it has a high withstand voltage in order that it can bear high voltage noise, while an internal circuit is required only to provide high speed operation.

In order to meet such requirements, a source-drain junction in the interface circuit should be formed relatively deeply and junction withstand voltage must be high. On the other hand, in the internal circuit the junction should be as shallow as possible with a view to making the junction area narrow. Therefore, an MOS transistor having a desired junction depth can be formed by means of the formation of a junction as mentioned previously by leaving only a comparatively thin covering of polycrystalline semiconductor on a source and drain forming window of an MOS transistor of the interface circuit whilst leaving a comparatively thick covering of polycrystalline semiconductor on a source and drain forming window of an MOS transistor of the internal circuit. A deep junction transistor has a gradually bending junction and a high junction withstand voltage.

In an embodiment of this invention, the polycrystalline semiconductor covering over source and drain regions is used to provide electrode contacts for the source and drain regions.

Reference is made, by way of example, to the accompanying drawings, in which:—

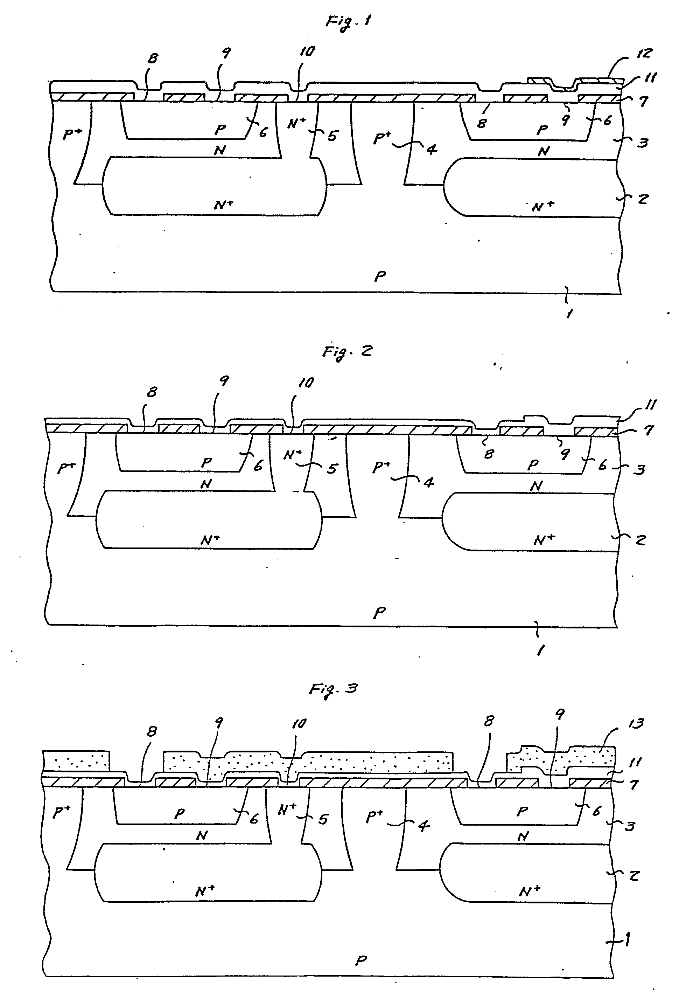

Figures 1 to 5 are respective partial schematic cross-sectional views illustrating process steps in the manufacture of an IC by a method embodying the present invention, wherein two transistors have the same base depth but have different emitter depths, one of the transistors being an internal circuit transistor and the other of the transistors being an input interface circuit transistor.

Figure 1 shows a partial sectional view of a semiconductor wafer on which undoped polycrystal silicon and silicon nitride have been coated, and which has been processed to form a part-completed ordinary bipolar IC. In the Figure, 1 is a P type silicon substrate; 2 is a $N^+$ type buried layer; 3 is a N type silicon epitaxial layer. Its specific resistance is 1 $\Omega$cm, as an example, and its thickness is 2.5 $\mu$m. 4 is a $P^+$ isolation diffusion region; 5 is a collector contact diffusion region which contacts the buried layer; 6 is a base region, which is formed by a single diffusion, having a sheet resistivity as an example, of 500 $\Omega$/square, and a depth of 0.6 $\mu$m. 7 is a silicon oxide film covering the silicon substrate surface. In selected areas of the oxide film, base electrode windows 8, emitter electrode windows 9 and a collector electrode window 10 are provided as shown. 11 is undoped polycrystal silicon of a thickness of 2000Å (200 nm). 12 is a silicon nitride film of a thickness of 500Å (50 nm).

A method of manufacturing a bipolar IC wherein all electrode windows are provided in silicon oxide film 7 and polycrystal silicon is used is explained in detail in U.S. Patent No. 4,125,426 which is assigned to the present applicants.

Both the polycrystal silicon 11 and the silicon nitride film 12 are provided by a chemical vapour deposition (CVD) method. The polycrystal silicon 11 can be formed to a uniform thickness by decomposition of monosilane $SiH_4$ under reduced pressure. Apparatus for obtaining such a polycrystal silicon layer is already on the market. Particular doping material is not required for the growth of polycrystal silicon 11, but it is allowed for that the polycrystal silicon can have some small conductivity due to unexpected or unintended impurity migration.

The polycrystal silicon 11 should be relatively thin at an emitter window 9 where a comparatively deep emitter is to be formed. In the present embodiment of this invention, the polycrystal silicon 11 is first provided everywhere with a uniform thickness and thereafter it is thinned down to a predetermined thickness at an emitter window 9 where a comparatively deep emitter is to be formed (i.e. at the lefthand side emitter window 9 in Figure 1). For this purpose, silicon nitride film 12 is provided as shown in Figure 1.

Selective etching of silicon nitride film 12 can be effected using well known $SiO_2$ as a mask and using hot phosphoric acid as etchant. After this etching, to leave only film 12 as shown in Figure 1, polycrystal silicon 11 is selectively oxidised using silicon nitride film 12 as a mask. When thermal oxidation is effected for a period of 150 minutes by applying oxygen gas which has passed through hot water at 100°C to an electric furnace heated up to 900°C, the polycrystal silicon 11 is oxidised from the surface thereof, and the thickness of the oxide film so formed reaches 2300Å (230 nm) for example. Thereafter, this oxide film is removed using hydrofluoric acid system etching solution and then silicon nitride film 12 is removed. Thus the polycrystal silicon 11 where not covered with the silicon nitride film 12 is reduced in thickness to 1000Å (100 nm) for example.

Figure 2 illustrates a layer structure thus obtained (thinner polycrystal silicon over the lefthand side window 9, thicker polycrystal silicon over the righthand side window 9).

Thereafter, the substrate 1 is put into pressure-reduced vapour growth apparatus in order to cause the growth of a phospho-silicate glass layer (PSG) 13. Reaction gases used are monosilane $SiH_4$, phosphine $PH_3$ and oxygen $O_2$. The flow rate of phosphine is 40% of the total flow rate of $SiH_4$ and $PH_3$. For the growth of PSG, the substrate 1 is heated up to 400°C and vapour growth is continued for 20 minutes. Thereby PSG 5000Å (500 nm) thick can be obtained. In Figure 3, this PSG is indicated by reference number 13. In addition, as shown in Figure 3, the PSG 13 is removed at least from over base electrode windows 8, but is left covering the emitter electrode windows 9 and collector electrode window 10.

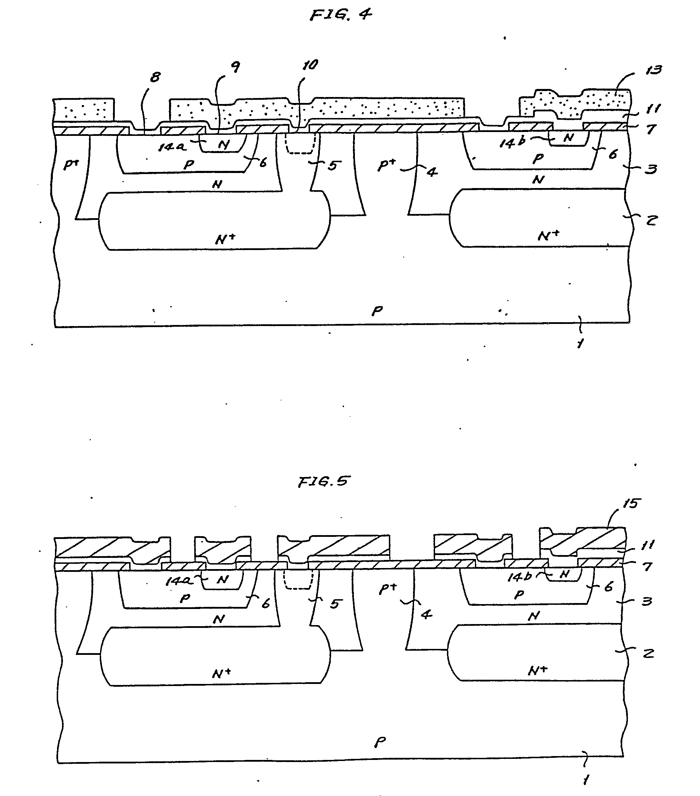

Next, a thermal process is continued for four (4) minutes at a temperature of 1100°C. During this thermal process, phosphorus in the PSG 13 passes through the different thicknesses of polycrystal silicon 11 and then diffuses into the silicon substrate 1, thus forming emitter regions 14a, 14b, as indicated in Figure 4. During this thermal process, impurity in the base regions 6 diffuse into the undoped polycrystal silicon 11, making the polycrystal silicon 11 in the base electrode windows 8 conductive. For this purpose it is recommended that P type impurity be diffused into bases 6 under base electrode windows 8 prior to the thermal process. The resistivity of the polycrystal silicon within the emitter electrode windows 9 and collector electrode window 10 is reduced by diffusion of phosphorus from the PSG 13. Phosphorus-doped polycrystal silicon of 4000Å (400 nm) thickness has a sheet resistivity of about 50 $\Omega$/square when it is formed by a CVD method and because this sheet resistivity can be reduced to 20 to 30 $\Omega$/square by means of the diffusion of phosphorus in the thermal process described above, this process is advantageous. Diffusion through the polycrystal silicon 11 has another advantage in that accuracy of diffusion can be improved. Namely, accuracy of diffusion depth or concentration can be improved to $\pm10\%$; it is only about $\pm20\%$ in the case of diffusion using doped poly-silicon.

After the diffusion of phosphorus, the silicon substrate 1 is dipped into hydrophosphoric acid system etching solution and thereby the PSG 13 is completely removed.

Thereafter, aluminium 15 is evaporated over the whole exposed surface to a thickness of about 1.0 $\mu$m, as electrode wiring material. Then, aluminium is formed into lead wiring by photolithography and polycrystal silicon 11 which is not covered by aluminium wiring is removed by nitric acid system etching solution. This provides a structure as illustrated in Figure 5.

In the sintering of aluminium, since polycrystal silicon exists under the aluminium, the aluminium does not penetrate to the silicon substrate, even when the aluminium and the polycrystal silicon are alloyed, and junctions in the silicon substrate are protected from breakdown.

For the comparatively shallow emitter region 14b, a comparatively thick covering of polycrystal silicon 11 is provided, preventing junction breakdown during sintering.

Transistors obtained as described with reference to Figures 1 and 5 have the following characteristics. The transistor having the deep emitter region 14a and the transistor having the shallow emitter region 14b are formed by the base diffusion method and exhibit the same collector-base withstand voltage of 40V. However, in the case of the former transistor, the current amplification factor is adjusted to 100 and $V_{CEO}$ is 7V. In the case of the latter transistor, the current amplification factor is 30 and $V_{CEO}$ is 14V. For this reason, the latter transistor is used as an input interface circuit transistor.

Processes similar to those described above in connection with the described embodiment can be used in a case in which the conductivity types of respective regions are inverted.

In the embodiment of Figures 1 to 5, different emitter depths are provided for in a single diffusion process, and in a similar way different base depths can also be provided for in a single diffusion.

Thereby, base diffusion processes for forming a junction breakdown type programmable read only memory (PROM) can be simplified.

A PROM of this type is required to have sufficient collector-emitter withstand voltage also, for cells for programming on the occasion of programming into the memory cells, and also has a configuration providing a PNPN thyristor structure between adjacent cells. Therefore, it is required to keep the current amplification factor of the PNPN structure small and as a result the base in a memory cell is deep as compared with a base in a peripheral circuit. An embodiment of the present invention can be adopted to provide a PROM having different base depths.

Thus, an embodiment of this invention provides a method of manufacturing a semiconductor device wherein a plurality of diffused regions (14a, 14b) can be simultaneously formed with different diffusion depths. A polycrystal semiconductor layer structure (11) different parts of which are of different thicknesses is formed on a semiconductor substrate (1) surface having a diffusion mask (7) having a plurality of diffusion windows (8, 9, 10). By impurity diffusion from the polycrystalline semiconductor surface, a comparatively shallow diffused region (14b) and a comparatively deep diffused region (14a) are formed by a single diffusion process, respectively under a comparatively thick part of the polycrystalline semiconductor layer structure and under a comparatively thin part of the polycrystalline semiconductor layer structure. The polycrystalline semiconductor layer is undoped (of course, it may have incidental doping impurities). The impurities for diffusion through the polycrystalline layer may be provided by a diffusion source coated on the polycrystalline layer, by gas diffusion, or by ion implantation, or by a diffusion source provided by ion implantation.

## Claims

1. A method of manufacturing a semiconductor device, comprising:—

forming an insulating film (7) on a surface of a semiconductor substrate (1), said film having first and second diffusion windows (9) and a third diffusion window (8) therein, through which corresponding portions of said surface of the semiconductor substrate are exposed.

forming undoped polycrystalline semiconductor on the surface portions of the semiconductor substrate exposed in the first, second and third diffusion windows in the insulating film, the undoped polycrystalline semiconductor on the surface portion exposed in the first diffusion window (9) and the undoped polycrystalline semiconductor on the surface portion exposed in the second diffusion window (9) having different selected thicknesses,

forming, simultaneously, diffusion regions, of different junction depths, in portions of the semiconductor substrate associated with the surface portions exposed in the first and second diffusion windows (9), by diffusing impurities into the substrate via the first and second diffusion windows, in each case through the respective selected thickness of polycrystalline semiconductor formed in the window concerned, and

simultaneously doping the undoped polycrystalline semiconductor on the surface portion exposed in the third diffusion window (8) by diffusion of impurity provided in a portion of the substrate associated with that surface portion into that undoped polycrystalline semiconductor.

2. A method as claimed in claim 1, comprising:—

forming an undoped polycrystalline semiconductor layer on the insulating film and extending through each of the first, second and third diffusion windows to contact the said corresponding portions of the surface of the semiconductor substrate, applying a protective mask (12) selectively over a portion of said polycrystalline semiconductor layer associated with the first diffusion window with respect to which a diffusion region of a first junction depth is to be formed, the remainder of said polycrystalline semiconductor layer being exposed at least as to the portion thereof extending through the second diffusion window with respect to which a diffusion region of a second junction depth, deeper than said first junction depth, is to be formed,

reducing the thickness of said polycrystalline semiconductor layer in the exposed portion thereof,

removing said protective mask, and

forming, simultaneously, said diffusion regions of both said first and second junction depths by diffusing impurities through said polycrystalline semiconductor layer.

3. A method as claimed in claim 2, wherein the reduction of the thickness of said polycrystalline semiconductor layer in the exposed portion thereof comprises:—

oxidising the exposed portion of the polycrystalline semiconductor layer, for converting a predetermined part of the thickness thereof to an oxide whilst retaining a desired remaining thickness thereof in an inconverted form, and removing the oxide by an oxide selective etchant.

4. A method as claimed in claim 1, 2 or 3, wherein a diffusion source (13), including the impurity to be diffused into the substrate via the first and second diffusion windows, is coated over the different selected thicknesses of polycrystalline semiconductor.

5. A method as claimed in claim 4, wherein the diffusion source is a glass film (13) including the impurity to be is diffused.

6. A method as claimed in claim 1, 2 or 3, wherein diffusion of impurity into the substrate via the first and second diffusion windows is effected by a gas diffusion method.

7. A method as claimed in claim 1, 2 or 3 wherein the diffusion of impurity into the substrate via the first and second diffusion windows is effected by an ion implantation method.

8. A method as claimed in claim 4, wherein the diffusion source is formed by an ion implantation method.

9. A method as claimed in any preceding claim, wherein electrode wire material (15) is formed on the polycrystalline semiconductor (after the diffusion of impurity), which is left in place as contact material.

10. A method as claimed in any preceding claim, wherein at least one of the said first and second diffusion regions is an emitter region.

11. A semiconductor device manufactured by a method as claimed in any preceding claim.

**Revendications**

1. Procéde de fabrication d'un dispositif semiconducteur, comprenant les opérations suivantes:

former une pellicule isolante (7) à la surface d'un substrat semiconducteur (1), ladite pellicule comportant une première et une deuxième fenêtre de diffusion (9) ainsi qu'une troisième fenêtre de diffusion (8), au travers desquelles des parties correspondantes de ladite surface du substrat semiconducteur sont exposées à découvert,

former une couche de semiconducteur polycristallin non dopé sur les parties superficielles du substrat semiconducteur exposées dans les première, deuxième et troisième fenêtres de diffusion formées dans la pellicule isolante, la couche de semiconducteur polycristallin non dopé se trouvant sur la partie superficielle exposée dans la première fenêtre de diffusion (9) et la couche de semiconducteur polycristallin non dopé se trouvant sur la partie superficielle exposée dans la deuxième fenêtre de diffusion (9) ayant des épaisseurs choisies différentes,

former simultanément des régions de diffusion d'épaisseurs de jonction différentes dans des parties du substrat semiconducteur associées aux parties superficielles exposées dans les première et deuxième fenêtres de diffusion (9) en faisant diffuser des impuretés dans le substrat au travers de la première et de la deuxième fenêtre de diffusion, dans chaque cas à travers l'épaisseur choisie respective de la couche de semiconducteur polycristallin formée dans la fenêtre considéré, et

doper simultanément le semiconducteur polycristallin non dopé se trouvant sur la partie superficielle exposée dans la troisième fenêtre de diffusion (8) en faisant diffuser des impuretés, disposées dans une partie du substrat associée à cette partie superficielle, dans ce semiconducteur polycristallin non dopé.

2. Procédé selon la revendication 1, comprenant les opérations suivantes:

former une couche de semiconducteur polycristallin non dopé sur la pellicule isolante et l'étendre sur chacune desdites première, deuxième et troisième fenêtres de diffusion afin qu'elle vienne en contact avec lesdites parties correspondantes de la surface du substrat semiconducteur,

appliquer un masque protecteur (12) sélectivement sur une partie de ladite couche de semiconducteur polycristallin associée à la première fenêtre de diffusion relativement à laquelle une région de diffusion d'une première profondeur de jonction doit être formée, le reste de ladite couche de semiconducteur polycristallin étant exposé au moins sur sa partie s'étendant sur la deuxième fenêtre de diffusion relativement à laquelle une région de diffusion d'une deuxième profondeur de jonction, plus grande que la première profondeur de jonction, doit être formée,

réduire l'épaisseur de ladite couche de semiconducteur polycristallin dans sa partie exposée.

retirer ledit masque protecteur, et

former simultanément lesdites régions de diffusion desdites première et deuxième profondeurs de jonction en faisant diffuser des impuretés au travers de ladite couche de semiconducteur polycristallin.

3. Procédé selon la revendication 2, où l'opération de réduction de l'épaisseur de ladite couche de semiconducteur polycrystallin dans sa partie exposée comprend les opérations suivantes:

oxyder la partie exposée de la couche de semiconducteur polycristallin afin de transformer une partie prédéterminée de son épaisseur en un oxyde tout en maintenant une épaisseur restante voulue de celle-ci sous une forme non transformée, et

retirer l'oxyde au moyen d'un agent d'incision attaquant sélectivement l'oxyde.

4. Procédé selon la revendication 1, 2 ou 3, où une source de diffusion (13), comportant les impuretés à faire diffuser dans le substrat via les première et deuxième fenêtres de diffusion, est déposée sur les épaisseurs choisies différentes du semiconducteur polycristallin.

5. Procédé selon la revendication 4, où la source de diffusion est une pellicule de verre

(13) contenant les impuretés à faire diffuser.

6. Procédé selon la revendication 1, 2 ou 3, où la diffusion des impuretés dans le substrat via les première et deuxième fenêtres de diffusion s'effectue par un procédé de diffusion gazeuse.

7. Procédé selon la revendication 1, 2 ou 3, où la diffusion des impuretés dans le substrat via les première et deuxième fenêtres de diffusion s'effectue par un procédé d'implantation ionique.

8. Procédé selon la revendication 4, où la source de diffusion est formée par un procédé d'implantation ionique.

9. Procédé selon l'une quelconque des revendications précédentes, où un matériau (15) pour fils d'électrodes est formé sur le semiconducteur polycristallin (après la diffusion des impuretés), qui est laissé en place comme matériau de contact.

10. Procédé selon l'une quelconque des revendications précédentes, où au moins l'une desdites première et deuxième régions de diffusion est une région d'émetteur.

11. Dispositif semiconducteur fabriqué par un procédé selon l'une quelconque des revendications précédentes.

**Patentansprüche**

1. Verfahren zur Herstellung einer Halbleitervorrichtung, gekennzeichnet durch:

Bildung eines isolierenden Films (7) auf einer Oberfläche eines Halbleitersubstrats (1), welcher erste und zweite Diffusionsfenster (a) und ein drittes Diffusionsfenster (8) hat, durch welche entsprechende Abschnitte der genannten Oberfläche des Halbleitersubstrats exponiert sind,

Bildung von undotiertem, polykristallinen Halbeiter auf den Oberflächenabschnitten des Halbleitersubstrats, welche in dem ersten, zweiten und dritten Fenster des isolierenden Films exponiert sind, wobei der undotierte, polykristalline Halbleiter auf dem Oberflächenabschnitt, der in dem ersten Diffusionsfenster (a) exponiert ist, und der undotierte polykristalline Halbleiter auf dem Oberflächenabschnitt, welcher in dem zweiten Diffusionsfenster (a) exponiert ist, verschieden ausgewählte Dicken aufweisen,

simultane Bildung von Diffusionsbereichen mit verschiedenen Grenzschichttiefen in Abschnitten des Halbleitersubstrats, welche den Oberflächenabschnitten zugeordnet sind, die in dem ersten und dem zweiten Diffusionsfenster (9) exponiert sind, durch Diffusion von Verunreinigungen in das Substrat durch das erste Diffusionsfenster und das zweite Diffusionsfenster, in jedem Fall durch die jeweils ausgewählte Dicke von polykristallinem Halbleiter, welcher in dem betreffenden Halbleiterfenster gebildet ist, und

simultane Dotierung des undotierten polykristallinen Halbleiters auf dem Oberflächenabschnitt, welcher in dem dritten Diffusionsfenster (8) exponiert ist, durch Diffusion von Verunreinigung, die in einem dem Oberflächenabschnitt des Substrats zugeordneten Abschnitt vorgesehen ist, in den undotierten polykristallinen Halbleiter.

2. Verfahren nach Anspruch 1, gekennzeichnet durch:

Bildung einer undotierten polykristallinen Halbleiterschicht auf dem isolierenden Film und Erstreckung derselben durch sowohl das erste, das zweite als auch das dritte Diffusionsfenster, um die genannten entsprechenden Abschnitte der Oberfläche des Halbleitersubstrats zu kontaktieren,

Aufbringen einer Schutzmaske (12) selektiv über einem Abschnitt der genannten polykristallinen Halbleiterschicht, welcher dem ersten Diffusionsfenster zugeordnet ist, in Bezug auf welches ein Diffusionsbereich von einer ersten Grenzschichttiefe gebildet werden soll, wobei der Rest der genannten polykristallinen Halbleiterschicht wenigstens bezüglich des Abschnittes von ihr exponiert ist, welcher sich durch das zweite Diffusionsfenster erstreckt, in Bezug auf welches ein Diffusionsbereich von einer zweiten Grenzschichttiefe, die tiefer als die erste Grenzschichttiefe ist, gebildet werden soll,

Reduzieren der Dicke der polykristallinen Halbleiterschicht in ihrem exponierten Abschnitt,

Entfernung der genannten Schutzmaske, und simultane Bildung der genannten Diffusionsbereiche sowohl von der genannten ersten Grenzschichttiefe als auch von der genannten zweiten Grenzschichttiefe durch Diffusion von Verunreinigungen durch die genannte polykristalline Halbleiterschicht.

3. Verfahren nach Anspruch 2, bei welchem die Reduktion der Dicke der genannten polykristallinen Halbleiterschicht in dem exponierten Abschnitt derselben umfaßt:

Oxidieren des exponierten Abschnitts der polykristallinen Halbleiterschicht, um einen vorbestimmten Teil der Dicke derselben zu einem Oxid zu konvertieren, während eine gewünschte verbleibende Dicke derselben in einer nichtkonvertierten Form zurückgehalten wird, und

Entfernen des Oxids durch ein oxidselektives Ätzmittel.

4. Verfahren nach Anspruch 1, 2 oder 3, bei welchem eine Diffusionsquelle (13), welche die in das Substrat über das erste und das zweite Diffusionsfenster zu diffundierende Verunreinigung umfaßt, über die verschiedenen ausgewählten Dicken von polykristallinem Halbleiter überzogen wird.

5. Verfahren nach Anspruch 4, bei welchem die Diffusionsquelle ein Glasfilm (13) ist, welcher die zu diffundierende Verunreinigung umfaßt.

6. Verfahren nach Anspruch 1, 2 oder 3, bei welchem die Diffusion von Verunreinigung in das Substrat durch das erste und das zweite Diffusionsfenster durch ein Gasdiffusionsverfahren bewirkt wird.

7. Verfahren nach Anspruch 1, 2 oder 3, bei welchem die Diffusion von Verunreinigung in das Substrat durch das erste und das zweite Diffusionsfenster durch ein Ionenimplantationsverfahren bewirkt wird.

8. Verfahren nach Anspruch 4, bei wlechem die Diffusionsquelle durch ein Ionenimplantationsverfahren gebildet wird.

9. Verfahren nach einem der vorhergehenden Ansprüche, bei welchem, (nach der Diffusion von Verunreinigung), Elektrodendrahtmaterial (15) auf dem polykristallinen Halbleiter gebildet wird, welches als Kontaktmaterial dort gelassen wird.

10. Verfahren nach einem der vorhergehenden Ansprüche, bei welchem wenigstens einer des ersten Diffusionsbereichs oder des zweiten Diffusionsbereichs ein Emitterbereich ist.

11. Halbleitervorrichtung, hergestellt nach einem Verfahren nach einem der vorhergehenden Ansprüche.

0 034 910

Fig. 1

Fig. 2

Fig. 3

1

## FIG. 4

## FIG. 5